# EUROPÄISCHE PATENTSCHRIFT

(11) **EP 2 528 095 B1**
(45) Veröffentlichungstag und Bekanntmachung des Hinweises auf die Patenterteilung: **25.12.2013**
(21) Anmeldenummer: 12161485.3
(22) Anmeldetag: 27.03.2012
(51) Int. Cl.: H01L 25/07, H01L 25/16, H01L 23/40, H01L 23/473

(54) **Leistungselektronisches System mit erstem und zweitem Subsystem**
High performance electronic system with first and second subsystem
Système électronique de puissance avec premier et deuxième sous-système

(30) Priorität: 24.05.2011 DE 102011076323
(43) Veröffentlichungstag der Anmeldung: 28.11.2012
(73) Patentinhaber: Semikron Elektronik GmbH & Co. KG Patentabteilung, 90431 Nürnberg (DE)
(72) Erfinder: Frank, Thomas, 91207 Lauf (DE); Popp, Rainer, 91580 Petersaurach (DE); Weiß, Stefan, 91315 Höchstadt (DE)

(56) Entgegenhaltungen:
- EP-A2- 2 261 973
- DE-A1-102008 018 841
- DE-A1-102009 037 257
- DE-A1-102009 055 882
- DE-C1- 10 127 947

## Beschreibung

Die Erfindung beschreibt ein integriertes leistungselektronisches System, vorzugsweise zur Ausbildung einer damit realisierten Schaltungsanordnung in Form eines Stromrichters, beispielhaft eines Drei-Phasen-Wechselrichters. Derartige Systeme finden bevorzugt Anwendung in elektrischen Antrieben verschiedener Arten von Fahrzeugen, speziell auch bei Nutzfahrzeugen.

Es ist grundsätzlich bekannt derartige leistungselektronische System aus einzelnen Leistungshalbleitermodulen beispielhaft gemäß der DE 10 2009 037 257 A1 mit externer Verschienung, also der Verbindung der externen Anschlusselemente der Leistungshalbleitermodule miteinander aufzubauen. Derartige Systeme weisen den Vorteil auf durch Skalierung beliebig an die notwendige Leistung angepasst werden zu können. Einher geht damit allerdings auch der Nachteil, dass diese System aus einer Mehrzahl von einzelnen Komponenten bestehen und somit keine kompakte Einheit ausbilden.

Es ist ebenso bekannt derartige leistungselektronische Systeme als integrierte Systeme, beispielhaft gemäß der DE 101 27 947A1 auszugestalten. Bei einem derartigen als Drei-Phasen-Wechselrichter aufgebauten Systemen sind den drei Phasen jeweils eigene Schalteinrichtungen zugeordnet, die mit einer gemeinsamen internen Gleichspannungsverbindung miteinander und mit externen Gleichspannungs-Lastanschlusselementen verbunden sind. Es ist bekannt diese Gleichspannungsverbindung unmittelbar mit einer gemeinsamen Kondensatoreinrichtung für alle Schalteinrichtungen zu verbinden. Derartige Systeme weisen den Vorteil einer kompakten Ausgestaltung bei gleichzeitig hervorragenden elektrischen Eigenschaften auf. Sie bergen allerdings den Nachteil, dass sie durch die Integration vieler Komponenten einer Skalierung und damit einer Anpassung an unterschiedliche Leistungen nicht einfach zugänglich sind.

Aus der EP 2 261 973 A2 ist weiterhin ein leistungselektronische System mit einer Umhausung, einer Kühleinrichtung, einer Stromrichterschaltung, einem Kondensator sowie ersten und zweiten internen und externen Verbindungseinrichtungenbekannt. Hierbei weist die Stromrichterschaltung ein Substrat mit einer Mehrzahl hierauf angeordneter und mittels der ersten internen Verbindungseinrichtung schaltungsgerecht verbundener Leistungshalbleiterbauelemente auf. Die erste interne Verbindungseinrichtung ist mit zugeordneten Anschlusselementen der Kondensatoren und zweiten internen Verbindungseinrichtungen verbunden. Die Umhausung umschließt zusammen mit der Kühleinrichtung die Stromrichterschaltung, die Kondensatoren und die internen Verbindungseinrichtungen, wobei der hierbei entstandene Innenraum mittels eines Isolierstoffes gefüllt ist. Weiterhin sind die Öffnungen an denen die ersten und zweiten Verbindungseinrichtungen die Umhausung oder die Kühleinrichtung durchdringen gegen Umwelteinflüsse abgedichtet.

Der Erfindung liegt die Aufgabe zugrunde ein leistungselektronisches System vorzustellen, das eine kompakte Einheit bildet und gleichzeitig einer einfachen Skalierung, also einer Anpassung an unterschiedliche Leistungen und auch der Ausbildung verschiedener Schaltungsanordnungen zugänglich ist.

Die Aufgabe wird erfindungsgemäß gelöst, durch ein leistungselektronisches System mit den Merkmalen des Anspruchs 1. Bevorzugte Ausführungsformen sind in den jeweiligen abhängigen Ansprüchen beschrieben.

Das vorgestellte leistungselektronische System weist eine Kühleinrichtung, mindestens ein erstes und mindestens ein zweites Subsystem, die mittels mindestens einer internen Verbindungseinrichtung miteinander schaltungsgerecht verbunden sind sowie ein die Subsysteme zur Kühleinrichtung hin überdeckendes Gehäuse auf. Vorzugsweise sind alle Subsysteme in einer Reihe nebeneinander angeordnet.

Das mindestens eine erste Subsystem weist eine Schalteinrichtung mit einem Kühlbauteil, einen Isolierstoffkörper und ein externes Wechselspannungs-Lastanschlusselement auf. Die Schalteinrichtung wird vorzugsweise aus einem elektrisch isolierenden Substrat mit auf dessen erster Hauptfläche angeordneten und schaltungsgerecht verbundenen Leistungshalbleiterbauelementen, die die leistungselektronischen Schaltung ausbilden, gebildet. Die Schalteinrichtung weist weiterhin interne Lastanschlusselemente verschiedener Polarität auf, von denen mindestens eines mit dem externen Wechselspannungs-Lastanschlusselement ein- oder mehrstückig verbunden ist.

Das Kühlbauteil ist hierbei mit der zweiten Hauptfläche des Substrats verbunden und hierüber in thermischem Kontakt mit den Leistungshalbleiterbauelementen zur Abführung der dort anfallenden Abwärme. Das Kühlbauteil selbst ist mit der Kühleinrichtung thermisch leitend verbundenen. Der Isolierstoffkörper umfasst hierzu die zugeordnete Schalteinrichtung, die als Halbbrückenschaltungen ausgebildet sein kann, und fixiert das gesamte Subsystem mittels Befestigungselementen zur Kühleinrichtung.

Das mindestens eine zweite Subsystem ist grundsätzlich analog dem ersten Subsystem aufgebaut, weist allerdings zusätzlich mindestens ein externes Gleichspannungs-Lastanschlusselement, vorzugsweise allerdings zwei, auf, das jeweils geeignet mit dem polaritätsgleichen internen Lastanschlusselement verbunden ist.

Zudem kann es vorteilhaft sein, wenn jedes erste und zweite Subsystem eine eigene Kondensatoreinrichtung aufweist, die mit dem jeweiligen Isolierstoffkörper zu ihrer Fixierung verbunden ist. Hierbei sind dann die Kontakteinrichtungen der Kondensatoreinrichtung mit den internen Lastanschlusselementen der Schalteinrichtung polaritätsrichtig elektrisch leitend verbunden.

Ebenso ist es bevorzugt, wenn das mindestens eine erste und das mindestens eine zweite Subsystem eine eigene Steuerschaltung mit einer eigenen zugehörigen Schaltplatine aufweist. Diese Schaltplatine kann mit dem jeweiligen Isolierstoffkörper zu ihrer Fixierung mechanisch verbunden sein. Ebenso kann diese Schaltplatine mit Hilfsanschlusselementen der Schalteinrichtung elektrisch leitend verbunden sein.

Alternativ kann es bevorzugt sein für eine Mehrzahl von Subsystem, unabhängig davon ob es sich um erste oder zweite Subsystemen handelt, eine gemeinsame Steuerschaltung mit einer zugehörigen Schaltplatine vorzusehen. Auch diese Schaltplatine kann dann mit den jeweiligen Isolierstoffkörpern der Subsysteme zu ihrer Fixierung mechanisch verbunden sein. Ebenso kann diese Schaltplatine mit Hilfsanschlusselementen der zugeordneten Schalteinrichtungen elektrisch leitend verbunden ist.

Um ein kompakte Ausgestaltung zu realisieren kann jegliche Schaltplatine mit der zugeordneten einzelnen Schalteinrichtung oder mit allen Schalteinrichtungen von nebeneinander angeordneten Subsystemen einen Winkel zwischen 60° und 90° einzuschließen.

Es kann weiterhin vorteilhaft sein die Schaltplatine in unmittelbarer Nähe des einen externes Wechselspannungs-Lastanschlusselements des zugeordneten Subsystems oder in mittelbarer Nähe der externen Wechselspannungs-Lastanschlusselemente der zugeordneten Subsysteme angeordnet ist. Dies ist insbesondere dann vorteilhaft, wenn die Schaltplatine mit mindestens einem auf einem externen Wechselspannungs-Lastanschlusselement vorgesehenen Stromsensor verbunden ist.

Die mindestens eine Verbindungseinrichtung verbindet polaritätsrichtig und elektrisch leitend interne Lastanschlusselemente des mindestens einen ersten Subsystems und bevorzugt auch des mindestens einen zweiten Subsystems mit externen Gleichspannungs-Lastanschlusselementen, vorgesehen als Teil mindestens eines zweiten Subsystems.

Die erfinderische Lösung wird an Hand der Ausführungsbeispiele gemäß den Fig. 1 bis 5 weiter erläutert.

Fig. 1 zeigt in dreidimensionaler Darstellung ein erstes erfindungsgemäßes leistungselektronisches System mit seinem Gehäuse.

Fig. 2 und 3 zeigen in dreidimensionaler Darstellung und teilweise in Explosionsdarstellung das erste leistungselektronische System ohne Gehäuse.

Fig. 4 zeigt eine Draufsicht auf das erste leistungselektronische System ohne Gehäuse.

Fig. 5 zeigt in dreidimensionaler Darstellung ein zweites erfindungsgemäßes leistungselektronisches System ohne Gehäuse.

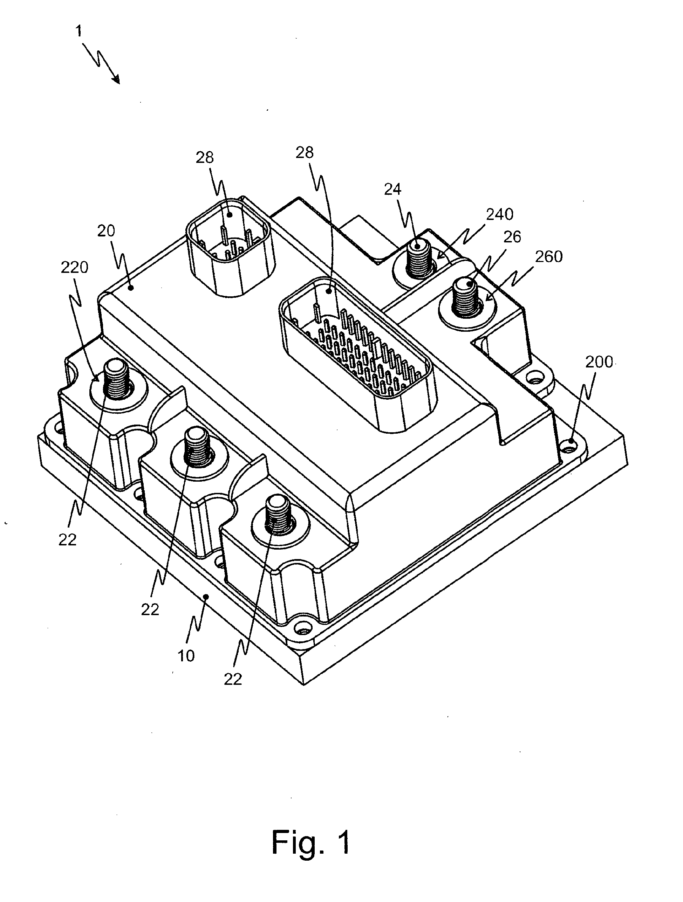

Fig. 1 zeigt in dreidimensionaler Darstellung ein erstes erfindungsgemäßes leistungselektronisches System 1 in Ausgestaltung eines Drei-Phasen-Wechselrichters. Schematisch dargestellt ist eine Kühleinrichtung 10, beispielhaft ausgebildet als eine Wasserkühleinrichtung. Interne Komponenten des Systems werden durch ein Gehäuse 20 zu dieser Kühleinrichtung 10 hin überdeckt. Das Gehäuse 10 selbst wird an entsprechenden Ausnehmungen 220, 240, 260 durch die externen Anschlusselemente 22, 24, 26 durchdrungen.

An einer ersten Seite des Gehäuses 10 sind die beiden externen Gleichspannungs-Lastanschlusselemente 24, 26 angeordnet, die als Schraubverbindungen ausgebildet sind. Auf der gegenüberliegenden zweiten Seite des Gehäuses 10 sind die externen Wechselspannungs-Lastanschlusselemente 22 in grundsätzlich gleicher technischer Ausprägung dargestellt.

An der Oberseite sind in zwei Gruppen externer Hilfsanschlusselemente 28 vorgesehen, die insbesondere zum Anschluss von Steuer- und Sensorsignalen dienen.

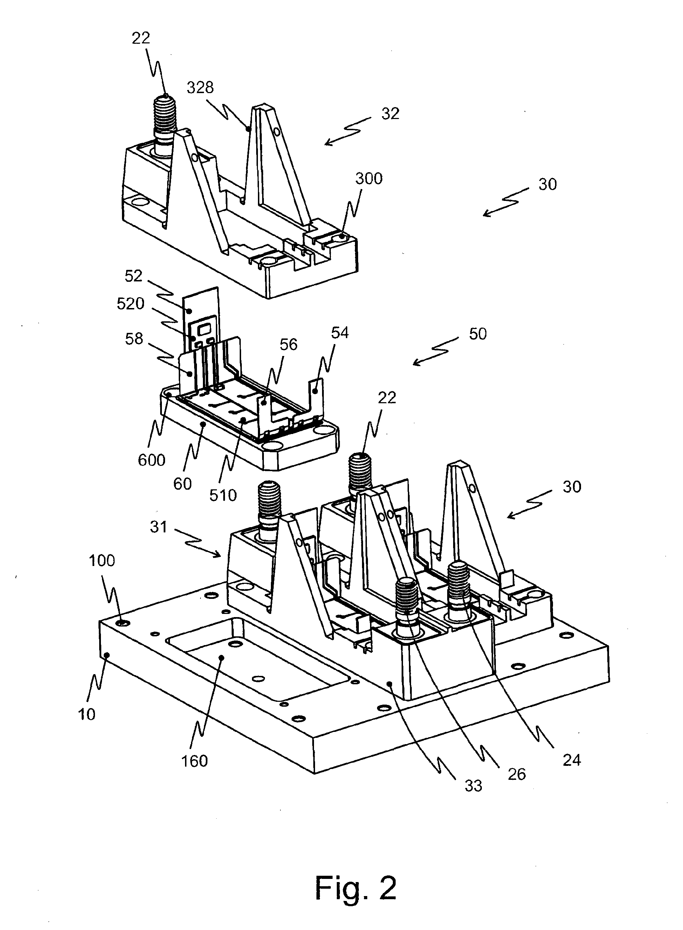

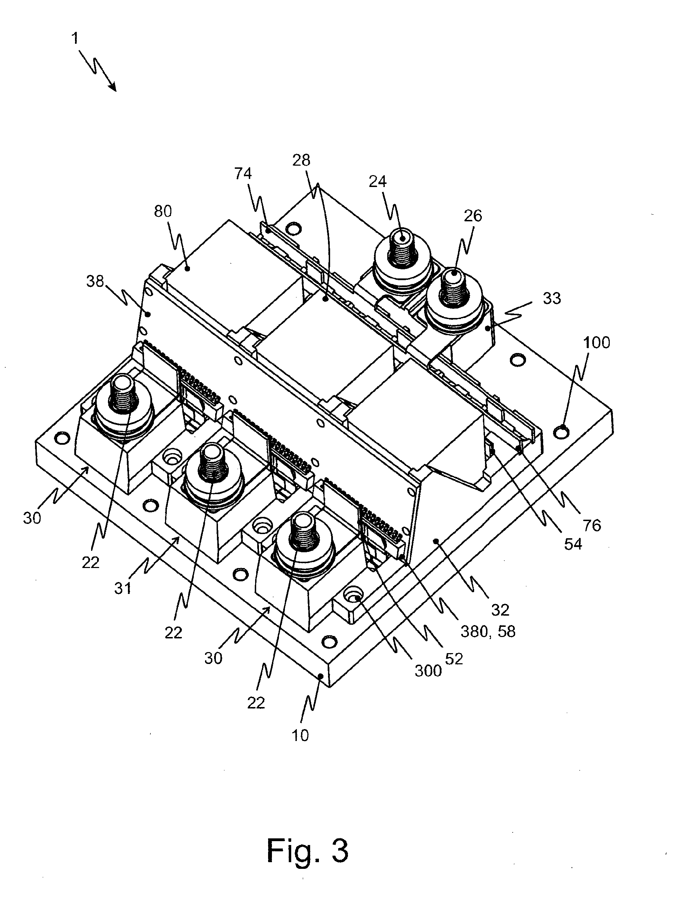

Fig. 2 und 3 zeigen in dreidimensionaler Darstellung und teilweise in Explosionsdarstellung das erste leistungselektronische System 1 ohne zugeordnetes Gehäuse mit teilweise unterschiedlichen Ausgestaltungen einzelner Details. Dargestellt ist wiederum eine Kühleinrichtung 10, hier mit einer Mehrzahl von Ausnehmungen 160, jeweils zur Anordnung von einzelnen Kühlbauteilen 60 von jeweils zugehörigen Subsystemen 30, 31. Es sind jeweils zwei erste 30 und ein zweites Subsystem 31 vorgesehen, wobei jedes dieser Subsysteme 30, 31 eine leistungselektronische Schaltung in Halbbrückentopologie beinhaltet wodurch das leistungselektronische System 1 eine Drei-Phasen-Brückenschaltung ausbildet.

Die beiden ersten Subsysteme 30 weisen jeweils ein Kühlbauteil 60 mit einem hierauf stoffschlüssig und thermische leitend verbundenen Substrat 510 auf. Auf der dem Kühlbauteil 60 gegenüberliegenden Seite des Substrats 510 ist die leistungselektronische Schaltung vorgesehen, die mit dem Substrat 510 und dem Kühlbauteil 60 die Schalteinrichtung 50 des Subsystems 30 bildet. Von der leistungselektronischen Schaltung gehen interne Anschlusselemente 52, 54, 56, 58 aus. Hier dargestellt sind die jeweils zwei Gleichspannungs-Lastanschlusselemente 54, 56, ein Wechselspannungslastanschlusselement 56 und eine Mehrzahl von Steueranschlusselementen 58. Diese Steueranschlusselemente 58 sind hier als Anschlusslaschen ausgebildet, wobei als Alternative hierzu, beispielhaft Federkontaktelemente oder Kontaktstifte, ebenfalls geeignet sind.

Die internen Lastanschlusselemente 52, 54, 56 sind jeweils als flächige Laschen ausgebildet. Das interne Wechselspannungs-Lastanschlusselement 52 weist einen hierauf angeordneten elektrisch isolierten Stromsensor 520 auf. In seinem Verlauf ist dieses interne Wechselspannungs-Lastanschlusselement 52 mit dem externen Wechselspannungs-Lastanschlusselement 22 kraft- oder vorzugsweise stoffschlüssig, beispielhaft ausgebildet mittels einer Schweißverbindung, verbunden. Das externe Wechselspannungs-Lastanschlusselement 22 ragt wie in Fig. 1 dargestellt durch das hier nicht dargestellte Gehäuse hindurch.

Angeordnet ist das externe Wechselspannungs-Lastanschlusselement 22 auf einem Isolierstoffkörper 32, der ebenfalls Teil des ersten Subsystems 30 ist. Dieser Isolierstoffkörper 32 umschließt weiterhin rahmenartig die Schalteinrichtung 50 und weist Befestigungseinrichtungen 300 auf, um das Subsystem 30 und damit auch die Schalteinrichtung 50 zur Kühleinrichtung 10 zu fixieren. In der dargestellten Ausgestaltung weist die Kühleinrichtung 10 jeweils eine Ausnahme 160, in Form einer Vertiefung, auf in der das zugeordnete Kühlbauteil 60 der Schalteinrichtung 50 vollständig zu liegen kommt. Somit kann der Isolierstoffkörper 32 flächig auf dem Kühlbauteil 10 aufliegen und somit die Schalteinrichtung 50 mechanisch robust zur Kühleinrichtung 10 fixieren. Somit wird die gesamte Schalteinrichtung 50 hierbei nur teilweise vom Isolierstoffkörper in demjenigen oberen Bereich, der aus der Kühleinrichtung 10 herausragt umfasst.

Weiterhin weist in Ausgestaltung gemäß Fig. 2 jeder Isolierstoffkörper 32 eine Halteeinrichtung 328 zur Fixierung einer zugeordneten nicht dargestellten Schaltplatine, die die Steuerschaltung für das Subsystem 30 beinhaltet, auf. Diese Schaltplatine ist hier in unmittelbarer Nähe zum internen Wechselspannungs-Lastanschlusselement 52 vorgesehen, um einerseits kurze Verbindungswege mit den internen Hilfsanschlusselementen 58 der Schalteinrichtung 50, wie auch mit dem auf dem internen Wechselspannungs-Lastanschlusselement 52 angeordneten Stromsensor 520 zu erlauben. Zur kompakten Ausgestaltung des gesamten leistungselektronischen Systems 1 ist die Schaltplatine 38 hier stehend, also unter einem Winkel zwischen 60° und 90° zur Schalteinrichtung 50, vorgesehen.

Die Ausgestaltung gemäß Fig. 3 zeigt eine grundsätzlich gleiche Anordnung der Schaltplatine 38, allerdings ist hier für alle drei Phasen eine gemeinsame Schaltplatine 38 vorgesehen, wodurch eine vereinfachte Ausgestaltung der Steuerschaltung möglich ist, da manche elektronische Komponenten nur einmal vorgesehen werden müssen.

Ebenso in Fig. 3, nicht aber in Fig. 2, dargestellt ist eine Kondensatoreinrichtung 80 je Subsystem 30, 31, die zu ihrer Fixierung, also ihrer mechanischen Befestigung, mit dem Isolierstoffkörper 32, 33 verbunden und hier sogar teilweise von diesem umschlossen bzw. umrahmt ist. Die Anschlusselemente des Kondensators 80 sind polaritätsrichtig mit den internen Gleichspannungs-Lastanschlusselementen 54, 56 der zugeordneten Schalteinrichtung 50 verbunden.

Zur Gleichspannungsversorgung weist das leistungselektronische System 1 zwei externe Gleichspannungs-Lastanschlusselemente 24, 26, eines mit positiver und eines mit negativer Polarität, auf, die beide Teil eines zweiten Subsystems 31 sind, das zwischen den beiden ersten Subsystemen 30 auf bzw. zu der Kühleinrichtung 10 angeordnet ist. Die externen Gleichspannungs-Lastanschlusselemente 24, 26 des zweiten Subsystems 31 sind mit zwei Verbindungseinrichtungen 74, 76 elektrisch leitend verbunden. Diese Verbindungseinrichtungen 74, 76 sind hier als flächige metallische Formkörper ausgebildet, jeweils mit einem ersten Kontaktabschnitt zur Verbindung mit den externen Gleichspannungs-Lastanschlusselementen und mit einem zweiten flächigen Abschnitt zur Verbindung elektrisch leitenden Verbindung mit den internen Gleichspannungs-Lastanschlusselementen 54, 56 der ersten 30 und des zweiten Subsystems 31.

Jeder der Isolierstoffkörper 32, 33 weist hierbei eine rechteckige Grundform auf, die auch die Grundform jedes Subsystems 30, 31 bildet. Die internen 52, 54, 56 und externen Lastanschlusselemente 22, 24, 26 sind hierbei derart den Schmalseiten dieser Grundform zugeordnet, dass die Isolierstoffkörper 32, 33 und damit die Subsysteme 30, 31 über ihre Längsseiten aneinander anreihbar sind um das leistungselektronische System 1 besonders kompakt auszugestalten.

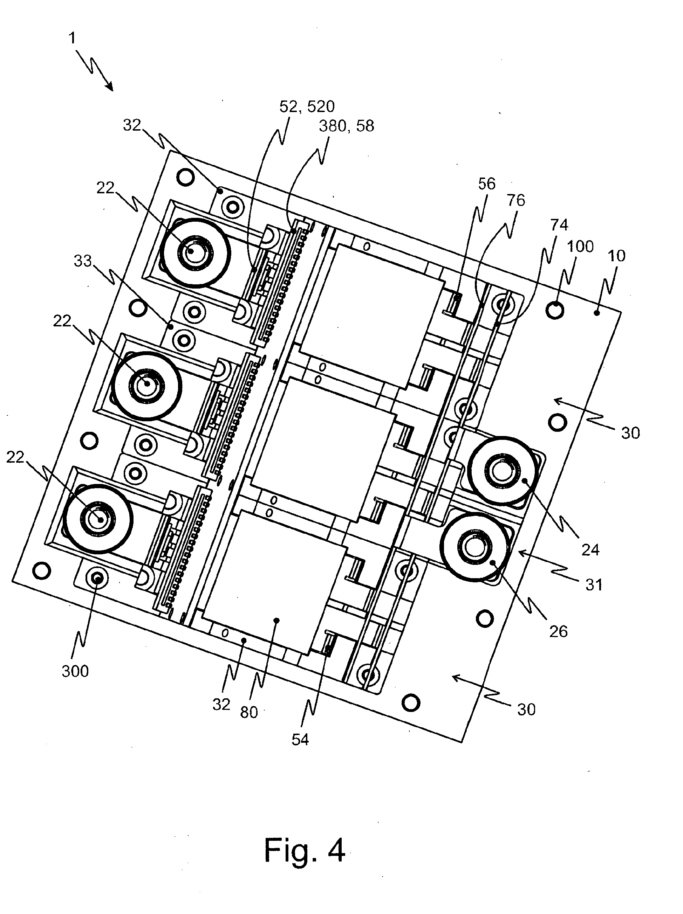

Fig. 4 zeigt eine Draufsicht auf das erste leistungselektronische System 1 analog demjenigen gemäß Fig. 3 ebenfalls ohne Gehäuse. Besonders deutlich ist hier die grundsätzliche Analogie der ersten 30 und zweiten Subsysteme 31 erkennbar, die sich nur durch das Vorhandensein von externen Gleichspannungs-Lastanschlusselementen 24, 26 und der zugehörigen Befestigung auf dem Isolierstoffkörper 33 unterscheiden. Ebenso erkennbar sind die Befestigungseinrichtungen 300 zur Fixierung der Subsysteme 30, 31 zur Kühleinrichtung 10. Ebenso wird hier der modulare Aufbau besonders offensichtlich, der grundsätzlich eine beliebige Aneinanderreihung von ersten 30 und zweiten Subsystemen 31 ermöglicht.

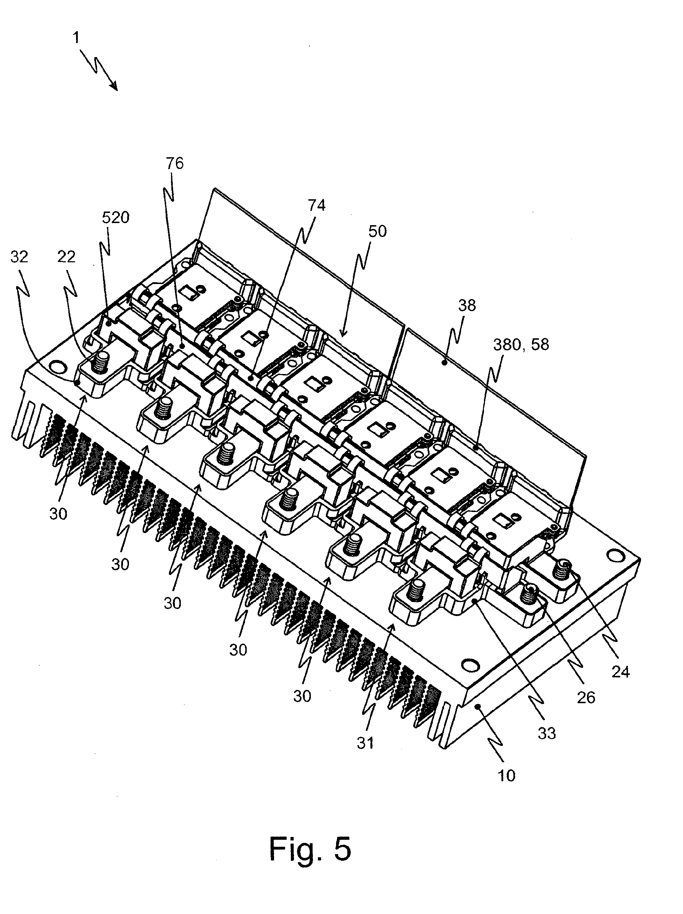

Fig. 5 zeigt in dreidimensionaler Darstellung ein zweites erfindungsgemäßes leistungselektronisches System 1 wiederum ohne Gehäuse. Dieses leistungselektronische System 1 weist zwei Drei-Phasen-Wechselrichter auf, die eine gemeinsame Gleichspannungsversorgung mittels zugeordneter externen Gleichspannungs-Lastanschlusselemente 24, 26 aufweisen. Derartige leistungselektronische Systeme 1 werden beispielhaft in elektrisch angetriebenen Flurförderzeugen verwendet, wobei ein Wechselrichter für die Fahrfunktionen und ein zweiter für die Hebefunktionen für Lasten vorgesehen sind. Das leistungselektronische System 1 besteht hierbei aus fünf ersten 30 und einem zweiten Subsystem 31, wobei drei erste Subsysteme 30 einen der beiden Wechselrichter ausbilden und zwei erste 30 und ein zweites Subsystem 31 den anderen Wechselrichter ausbilden.

Die ersten Subsysteme 31 weisen wiederum eine Schalteinrichtung 50 auf, die mit der Kühleinrichtung 10 thermisch leitend verbunden ist. Weiterhin weisen sie interne Gleichspannungs- und Wechselspannungs-Lastanschlusselemente auf, die beide auf einer Schmalseite der Schalteinrichtung 50 vorgesehen sind. Die jeweiligen internen Wechselspannungs-Lastanschlusselemente sind mit zugeordneten externen Wechselspannungs-Lastanschlusselementen 22 verbunden, deren Schraubanschlüsse derart ausgebildet sind, dass sie das nicht dargestellte Gehäuse durchdringen. Zudem ist hier jedem externen Wechselspannungs-Lastanschlusselement 22 ein Stromsensor 520 zugeordnet.

Das einzige zweite Subsystem 31 weist zusätzlich orthogonal zu dem externen Wechselspannungs-Lastanschlusselement 22 angeordnet die beiden externe Gleichspannungs-Lastanschlusselemente 24, 26 auf, die der Versorgung des gesamten leistungselektronischen Systems dienen. Hierzu sind diese externen Gleichspannungs-Lastanschlusselemente 24, 26 mittels zweier Verbindungseinrichtungen 74, 76 mit allen internen Gleichspannungs-Lastanschlusselementen aller Schalteinrichtungen der ersten 30 und des zweiten Subsystems 31 verbunden.

Jeder der beiden Wechselrichter weist seinen ihn bildenden Subsystemen 30, 31 zugeordnet eine Steuerschaltung auf. Diese Steuerschaltungen weisen jeweils eine Schaltplatine 38 auf, die auf der zweiten Schmalseite der Subsystem 30, 31 angeordnet ist und die in einem Winkel von circa 90 Grad zu der Orientierung der Schaltplatinen 38 der Subsysteme 30, 31 vorgesehen ist. Da oberhalb, auf der der Kühleinrichtung abgewandten Seite der Schalteinrichtungen 50 mindestens eine zugeordnete Kondensatoreinrichtung vorgesehen sein kann ergibt diese Anordnung der Schaltplatinen 38 eine besonders kompakte Ausgestaltung des gesamten leistungselektronischen Systems 1.

## Patentansprüche

1. Leistungselektronisches System (1) mit einer Kühleinrichtung (10), mindestens einem ersten (30) und mindestens einem zweiten Subsystem (31), mindestens einer Verbindungseinrichtung (74, 76) und einem Gehäuse (20), wobei
das mindestens eine erste Subsystem (30) eine Schalteinrichtung (50) mit einem mit der Kühleinrichtung (10) thermisch leitend verbundenen Kühlbauteil (60) und einer hierauf angeordneten leistungselektronischen Schaltung mit ersten internen Lastanschlusselementen (52, 54, 56) verschiedener Polarität, einen Isolierstoffkörper (32) und ein externes Wechselspannungs-Lastanschlusselement (22) aufweist,
das mindestens eine zweite Subsystem (31) analog dem ersten Subsystem (30) aufgebaut ist und zusätzlich mindestens ein externes Gleichspannungs-Lastanschlusselement (24, 26) aufweist,
wobei die mindestens eine Verbindungseinrichtung (74, 76) interne Gleichspannungs-Lastanschlusselemente (54, 56) der ersten (30) und zweiten Subsysteme (31) mit externen Gleichspannungs-Lastanschlusselementen (24, 26) des mindestens einen zweiten Subsystems (31) polaritätsrichtig elektrisch leitend verbindet und wobei das Gehäuse (20) alle Subsysteme (30, 31) zur Kühleinrichtung (10) hin überdeckt und wobei
der Isolierstoffkörper (32, 33) die zugeordnete Schalteinrichtung (50) zumindest teilweise umfasst und das jeweilige erste (30) oder zweite Subsystem (31) mittels Befestigungselementen (300) zur Kühleinrichtung (10) fixiert.

2. Leistungselektronisches System nach Anspruch 1, wobei
jedes erste (30) und zweite Subsystem (31) eine Kondensatoreinrichtung (80) aufweist, die mit dem jeweiligen Isolierstoffkörper (32, 33) zu ihrer Fixierung verbunden ist und die mit den ersten internen Gleichspannungs-Lastanschlusselementen (54, 56) der Schalteinrichtung (50) polaritätsrichtig elektrisch leitend verbunden ist.

3. Leistungselektronisches System nach Anspruch 1, wobei
jedes erste (30) und zweite Subsystem (31) eine Steuerschaltung mit einer zugehörigen Schaltplatine (38) aufweist, die mit dem jeweiligen Isolierstoffkörper (32, 33) zu ihrer Fixierung verbunden ist und die mit Hilfsanschlusselementen (58) der Schalteinrichtung (50) elektrisch leitend verbunden ist.

4. Leistungselektronisches System nach Anspruch 1, wobei
für eine Mehrzahl von Subsystemen (30, 31) eine gemeinsam Steuerschaltung mit einer zugehörigen Schaltplatine (38) vorgesehen ist, die mit den jeweiligen Isolierstoffkörpern (32, 33) der Subsysteme (30, 31) zu ihrer Fixierung verbunden ist und die mit Hilfsanschlusselementen (58) der zugeordneten Schalteinrichtungen (50) elektrisch leitend verbunden ist.

5. Leistungselektronisches System nach Anspruch 4, wobei
die Schaltplatine (38) mit der Schalteinrichtung (50) einen Winkel zwischen 60° und 90° einschließt.

6. Leistungselektronisches System nach Anspruch 4 oder 5, wobei
die Schaltplatine (38) in unmittelbarer Nähe mindestens eines externen Wechselspannungs-Lastanschlusselements (22) angeordnet ist und mit mindestens einem auf diesem externen Wechselspannungs-Lastanschlusselement (22) oder auf dem zugeordneten internen Wechselspannungs-Lastanschlusselement (52) vorgesehenen Stromsensor (520) verbunden ist.

7. Leistungselektronisches System nach Anspruch 1, wobei
die jeweiligen leistungselektronischen Schaltungen (40) als Halbbrückenschaltungen ausgebildet sind.

## Claims

1. A high performance electronics system (1) with a cooling device (10), at least one first (30) and at least one second subsystem (31), at least one connecting device (74, 76) and a housing (20), wherein the at least one first subsystem (30) has a switching device (50) with a cooling module (60) connected in a thermally conducting manner with the cooling device (10) and hereon arranged a high performance electronics circuit with first internal load terminals (52, 54, 56) of differing polarities, an insulating body (32) and an external AC load terminal (22), the at least one second subsystem (31) is constructed in an analogous manner to the first subsystem (30), and in addition has at least one external DC load terminal (24, 26), wherein the at least one connection device (74, 76) connects internal DC load terminals (54, 56) of the first (30) and second subsystems (31) in an electrically conducting manner with external DC load terminals (24, 26) of the at least one second subsystem (31) with the correct polarity, and wherein the housing (20) covers all subsystems (30, 31) as far as the cooling device (10), and wherein the insulating material body (32, 33) comprises at least partially the associated switching device (50), and secures the respective first (30) or second subsystem (31) by means of attachment elements (300) to the cooling device (10).

2. The high performance electronics system in accordance with Claim 1, wherein each first (30) and second subsystem (31) has a capacitor device (80), which is connected with the respective insulating body (32, 33) for purposes of securement, and which is connected in an electrically conducting manner with the first internal DC load terminals (54, 56) of the switching device (50) with the correct polarity.

3. The high performance electronics system in accordance with Claim 1, wherein each first (30) and second subsystem (31) has a control circuit with a related circuit board (38), which is connected with the respective insulating material body (32, 33) for purposes of securement, and which is connected in an electrically conducting manner with ancillary terminals (58) of the switching device (50).

4. The high performance electronics system in accordance with Claim 1, wherein a common control circuit with a related circuit board (38) is provided for a multiplicity of subsystems (30, 31); this is connected with the respective insulating bodies (32, 33) of the subsystems (30, 31) for purposes of securement, and is connected in an electrically conducting manner with ancillary terminals (58) of the associated switching devices (50).

5. The high performance electronics system in accordance with Claim 4, wherein the circuit board (38) subtends an angle of between 60° and 90° with the switching device (50).

6. The high performance electronics system in accordance with Claim 4 or 5, wherein the circuit board (38) is arranged in the immediate vicinity of at least one external AC load terminal (22) and is connected with at least one current sensor (520) provided on this external AC load terminal (22), or on the associated internal AC load terminal (52).

7. The high performance electronics system in accordance with Claim 1, wherein the respective high performance electronics circuits (40) are designed as half bridge circuits.

## Revendications

1. Système électronique de puissance (1) avec un dispositif de refroidissement (10), au moins un premier (30) et au moins un deuxième sous-système (31), au moins un dispositif de connexion (74, 76) et un boîtier (20), où le ou les premiers sous-systèmes (30) comportent un dispositif de commutation (50) avec un composant de refroidissement (60) relié de manière thermiquement conductrice au dispositif de refroidissement (10) et un circuit électronique de puissance disposé sur celui-ci, avec de premiers éléments de connexion de charge internes (52, 54, 56) de polarités différenciées, un corps isolant (32) et un élément de connexion de charge à tension alternative externe (22), où le ou les deuxièmes sous-systèmes (31) sont construits de manière analogue au premier sous-système (30) et comportent en outre au moins un élément de connexion de charge à tension continue externe (24, 26), où
le ou les dispositifs de connexion (74, 76) relient de manière électriquement conductrice et en respectant la polarité les éléments de connexion de charge à tension continue internes (54, 56) des premiers (30) et des deuxièmes sous-systèmes (31) aux éléments de connexion de charge à tension continue externes (24, 26) du ou des deuxièmes sous-systèmes (31), où le boîtier (20) recouvre tous les sous-systèmes (30, 31) jusqu'au dispositif de refroidissement (10), et où
le corps isolant (32, 33) comprend au moins en partie le dispositif de commutation (50) correspondant, et chaque premier (30) ou chaque deuxième sous-système (31) sont fixés au moyen d'éléments de fixation (300) au dispositif de refroidissement (10).

2. Système électronique de puissance selon la revendication 1, où
chaque premier (30) et chaque deuxième sous-système (31) comporte un dispositif de condensateur (80) relié pour sa fixation au corps isolant (32, 33) correspondant, et relié de manière électriquement conductrice et en respectant la polarité aux premiers éléments de connexion de charge à tension continue internes (54, 56) du dispositif de commutation (50).

3. Système électronique de puissance selon la revendication 1, où
chaque premier (30) et chaque sous-système (31) comporte un circuit de commande avec une platine de commutation (38) correspondante, relié pour sa fixation au corps isolant (32, 33) correspondant, et relié de manière électriquement conductrice à des éléments de commutation auxiliaires (58) du dispositif de commutation (50).

4. Système électronique de puissance selon la revendication 1, où
pour une pluralité de sous-systèmes (30, 31), il est prévu un circuit de commande commun avec une platine de commutation (38) correspondante, relié pour sa fixation aux corps isolants (32, 33) des sous-systèmes (30, 31) respectifs, et relié de manière électriquement conductrice à des éléments de commutation auxiliaires (58) des dispositifs de commutation (50) correspondants.

5. Système électronique de puissance selon la revendication 4, où
la platine de commutation (38) forme avec le dispositif de commutation (50) un angle compris entre 60° et 90°.

6. Système électronique de puissance selon la revendication 4 ou 5, où
la platine de commutation (38) est disposée à proximité immédiate d'au moins un élément de connexion de charge à tension alternative externe (22), et est reliée à au moins un capteur de courant (520) prévu sur ledit élément de connexion de charge à tension alternative externe (22) ou sur l'élément de connexion de charge à tension alternative interne (52) correspondant.

7. Système électronique de puissance selon la revendication 1, où
les différents circuits (40) électroniques de puissance sont réalisés sous forme de circuits demi-ponts.
